# EUROPEAN PATENT APPLICATION

(11) **EP 1 016 993 A1**
(43) Date of publication of application: **05.07.2000**
(21) Application number: 98830805.2
(22) Date of filing: 31.12.1998
(51) Int. Cl.: G06F 17/50

(54) **Method for simulating a data processing system having modules of more advanced versions**

(71) Applicant: BULL S.A., 78434 Louveciennes Cedex (FR)
(72) Inventor: Bosisio, Giuseppe, 20099 Sesto San Giovanni - Milano (IT)
(74) Representative: Pezzoli, Ennio

(57) **Abstract**

Method for simulating a new data processing system (200n), formed from a corresponding old processing system, comprising a plurality of interconnected modules (C1o-C4o, 215, 220, 225, 230) and in which at least one new of modules (C1n-C4n) replaces at least one corresponding old module (C1o-C4o) of the old processing system, the method comprising the step of supplying a functional model of the at least one old module (C1o-C4o) for simulating its functionality, in which are provided the steps of supplying the functional model of at least one adapting module (A1-A2) associated with the at least one old module (C1o-C4o) and connecting logically the at least one adapting module (A1-A4) between the at least one old module (C1o-C4o) and the other modules (215, 220, 225, 230) of the new processing system (200n), the functional model of the at least one old module (C1o-C4o) and of the at least one adapting module (A1-A4) being capable of simulating, at least partially, the functionality of the corresponding at least one new module (C1n-C4n).

## Description

The present invention relates to a method for simulating a data processing system, and in particular a method according to the precharacterizing clause of the first claim.

A data processing system generally consists of a series of interconnected modules, for example one or more processors, a memory control unit, an arbitration unit, and similar. Each module is formed from a physical structure (hardware) designed and constructed to carry out a particular task, typically executed by means of an integrated circuit specific to a given application (Application Specific Integrated Circuit, or ASIC).

The data processing system is frequently designed by means of computer aided engineering (CAE) methods. In particular, a functionality of each module is defined by a logical functional model, from which the circuit structure of the module can be derived automatically by means of suitable programs (synthesizers). Before the modules of the processing system are physically constructed, their operation is tested in a simulation environment by means of a simulator. The simulator consists of a software application which can be used to simulate the operation of the processing system, and in particular an interaction of the various modules, described by means of their functional model.

During the life cycle of a range of processing systems, it is common practice to replace one or more modules, for example the processors, with corresponding new modules of more advanced version. Consequently, in the new processing system produced in this way, the other modules have to be modified to adapt them to the functionality of the new processors. These modified modules are designed as soon as the functionality of the new processor is known, and before this processor is physically available. It is therefore necessary to have the functional model of the new processor available in order to simulate the operation of the new processing system. The functional model is supplied in a version compiled by a manufacturer of the new processor; it enables a real behaviour of the new processor to be simulated and is exercisable by suitable functional programs.

However, with this known solution the investment previously made for the design of the (old) processing system cannot be safeguarded in any way. In particular, it requires the acquisition of the functional model of the new processor, which is rather expensive and not always available; this also requires rather long wait times, with a consequent delay of the whole process of designing the new processing system.

Moreover, the use of the functional model of the new processor makes it necessary to produce a new test plan for the processing system. The test plan consists of a data bank of software tests of varying complexity, compiled and classified according to their type; each of these tests, of which there are generally several thousand, comprises, in particular, a phase of initialization of the processing system and a check of the outcome of the test, the whole being executed automatically. The necessity of producing a new test plan therefore introduces additional costs and delays into the design process.

The object of the present invention is to overcome the aforesaid drawbacks. To achieve this object, a method is proposed for simulating a data processing system as described in the first claim.

Briefly, the present invention provides a method for simulating a new data processing system, formed from a corresponding old processing system, comprising a plurality of interconnected modules and in which at least one new of the modules replaces at least one corresponding old module of the old processing system, the method comprising the step of supplying a functional model of the at least one old module for simulating its functionality, in which are provided the steps of supplying the functional model of at least one adapting module associated with the at least one old module and of connecting logically the at least one adapting module between the at least one old module and the other modules of the new processing system, the functional model of the at least one old module and of the at least one adapting module being capable of simulating, at least partially, the functionality of the corresponding at least one new module.

The present invention also proposes a simulator corresponding to this method.

Further characteristics and the advantages of the method for simulating a data processing system according to the present invention will be made clear by the description given below of a preferred embodiment of the invention, provided for information and without restriction, with reference to the attached figures, in which
Fig. 1 is a simulator which can be used to implement the method according to the present invention;
Figs. 2a and 2b are schematic block diagrams of a data processing system for which the method according to the present invention can be used;
Fig. 3 is a schematic illustration of the structure of the adapting module;
Figs. 4a and 4b show, in timing diagrams, various examples of simulated transactions.

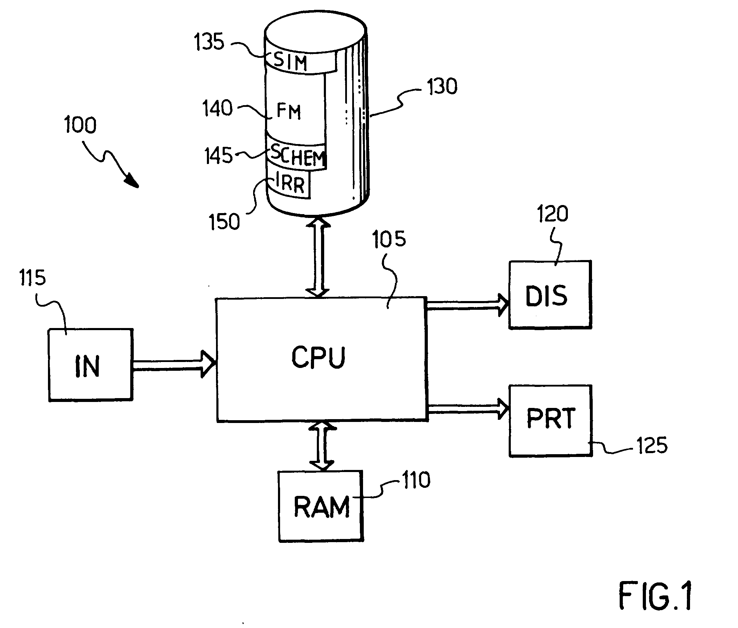

With reference in particular to Fig. 1, a simulator 100 produced by means of a workstation is illustrated; similar considerations are applicable if another equivalent simulator is used. The simulator 100 includes a central processing unit (CPU) 105 which is associated with a working memory 110, typically a random access memory (RAM). The CPU 105 is connected in a conventional way to an input unit (IN) 115 (for example a keyboard, with the addition, if necessary, of a pointing device such as a mouse), a display unit (DIS) 120 (for example a monitor), a printer (PRT) 125, and a backing memory 130, for example a fixed magnetic disk (hard disk) and drivers for reading from and writing to magnetic diskettes (floppy disks), optical discs (CD-ROM) or other equivalent media.

A simulation program (SIM) 135 (described in detail below) is stored in the backing memory 130. The backing memory 130 also contains a set of functional models (FM) 140 for each type of module of a data processing system to be simulated. The functional model consists of a set of instructions in an appropriate high-level language (Hardware Design Language, or HDL), typically stored in one or more files; these instructions describe a functionality of the module of the processing system, for example its logical behaviour, its timing, or similar. Schematic diagrams, or schematics, (SCHEM) 145, produced by means of a suitable graphics editor, are also used to logically interconnect the various modules of the processing system (similar considerations are applicable if other equivalent means are provided).

During a simulation process, the CPU 105 loads the simulation program (read from the backing memory 130) into the working memory 110. The operation of the processing system is checked by using stimulators, or irritators (IRR) 150, stored in suitable files of the backing memory 130. The content of these files is used to initialize the processing system; for example, the simulation program sets the content of a memory of the processing system, the content of registers within the various modules, and in particular the content of a program counter of each processor of the processing system in such a way that it points to a predetermined instruction of a program stored in this memory, and similar.

The program then simulates a clock signal of the processing system and activates all the modules of the system; for each module, the operations associated with its status and with input signals are thus executed, by interpretation of the instructions in HDL of the corresponding functional model. Alternatively, the functional models of one or more modules are compiled in advance in such a way that they can be executed directly at a higher speed.

At a subsequent clock signal, each module generates output signals which are displayed on the monitor 120 or reproduced on paper by the printer 125; at the same time, selected internal signals of each module are also displayed or reproduced. Alternatively, the output signals and the internal signals are stored in a file in the backing memory 130, to be compared subsequently with corresponding awaited signals stored in a further file, in such a way that an outcome of the simulation process is automatically monitored.

The simulation program then continues by generating successive clock signals, until a condition of the end of the simulation process is found, for example an error or the end of the program being executed in the various processors of the processing system.

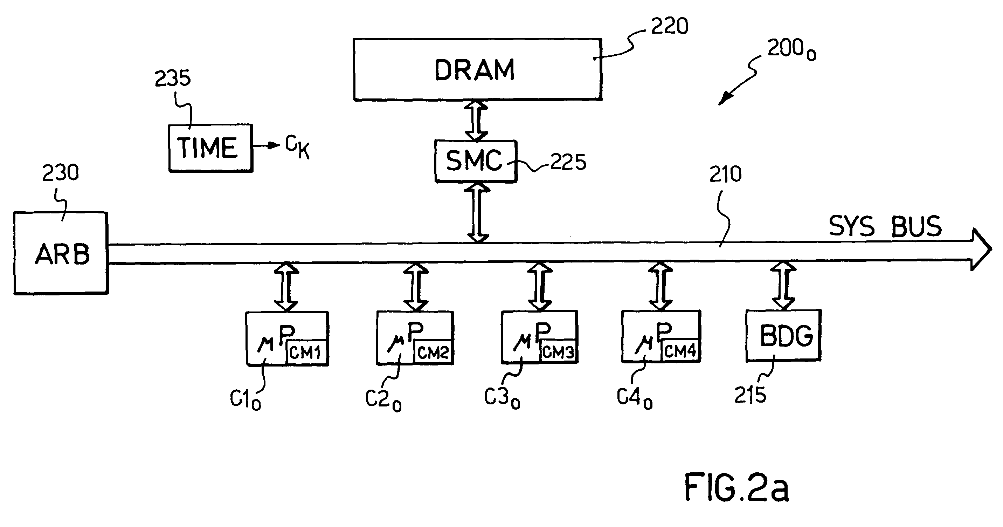

With reference now to Fig. 2a, an illustration is provided of a data processing system 200o comprising a system bus (SYS BUS) 210 consisting of various portions, one being used for the transmission of addresses (the address bus), one for data (the data bus) and one for commands (the control bus). A plurality of microprocessors (µP) C1o, C2o, C3o, C4o (four in the illustrated example) are connected in parallel to the system bus 210. A bridge unit (BDG) 215, is also connected to the system bus 210, and controls the interconnection with a local bus (not shown in the figure) to which a group (cluster) of input/output units is connected. The processing system 200o includes a shared memory 220, typically of the dynamic random access type (DRAM), connected to the system bus 210 by a control unit (System Memory Control, or SMC) 225. Each of the processors C1o, C2o, C3o, C4o is provided with an internal memory of the cache type (generally at two levels), indicated by CM1, CM2, CM3, CM4 respectively, in which data (cache lines) of the shared memory 220 are replicated.

The agents C1o-C4o, 215 and 225 are connected simultaneously (in what is called a slave mode) to the system bus 210 to receive data transmitted along this bus; the mutually exclusive access (in what is called the master mode) to the system bus 210 by these agents for sending data is controlled by a suitable arbitration unit (ARB) 230. A timing unit (TEMP) 235 generates a clock signal Ck which is supplied to the various modules of the processing system 200o (processors C1o-C4o, bridge unit 215, memory 220, memory control unit 225 and arbitration unit 230) to synchronize their operation.

Similar considerations are applicable if the modules of the processing system are interconnected in another way, for example by means of a crossbar, if a different number of processors (in the limit case, only one) is provided, or if the processing system has a different architecture (of the cc-NUMA type, for example), or similar.

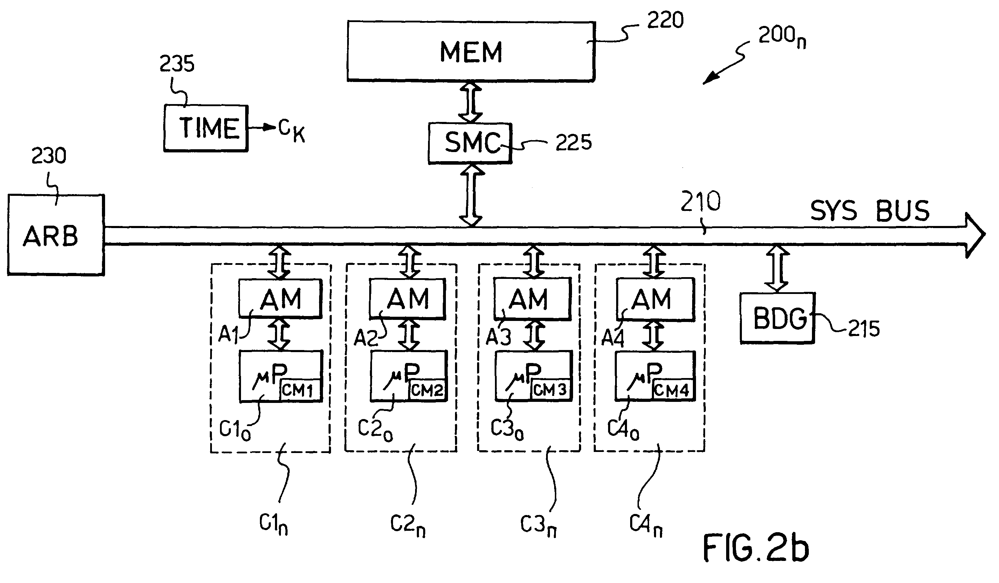

With reference now to Fig. 2b (the elements previously represented in Fig. 2a are identified with the same reference numbers or symbols), a new data processing system 200n is considered; this is obtained from the (old) data processing system described above, by replacing the (old) processors C1o-C4o with corresponding new, more advanced versions of processors C1n-C4n, and by correspondingly modifying one or more of the other modules (however, the method according to the present invention is also suitable for use in the case in which other modules of the old processing system are replaced). The processors C1o-C4o and C1n-C4n belong to the same family, and therefore have a relatively similar functionality, since it is generally necessary to maintain a compatibility between the old processors C1o-C4o and the new processors C1n-C4n. For example, the processors C1o-C4o and C1n-C4n have the same set of instructions (or the new processors C1n-C4n have all the instructions used in the old processors C1o-C4o with some additional instructions), have the same timing, and similar; additionally, the processors C1o-C4o and C1n-C4n all have external interfaces compatible with a communications protocol of the system bus 210. In general, the new processors C1n-C4n differ from the old processors C1o-C4o in a method of controlling the internal queues (for the input and output signals), in the length of the data elements used, in the number of blocks (beat) of each data element transmitted in succession along the system bus 210 (if the data is transmitted in burst mode), in the number of bits in each block, in an order (alignment) with which the blocks of a data element may be requested by the processor, and similar.

In the simulation method according to the present invention, the functional model of an adapting module (AM), described in detail below, associated with the old processors C1o-C4o, is provided. Each adapting module A1, A2, A3, A4 is connected logically between the old processor C1o, C2o, C3o, C4o respectively and the other modules of the new processing system 200n (in other words, to the system bus 210 in the example in question). The functional models of the adapting modules A1-A4 and of the old processors C1o-C4o are capable of simulating most of the functionality of the corresponding new processors C1n-C4n.

This solution makes it possible to safeguard the investments made for the acquisition of the functional model of the old processors C1o-C4o; conversely, the production of the functional model of the adapting modules A1-A4 is relatively simple, and the method according to the present invention is therefore particularly advantageous from an economic point of view.

This also makes it possible to start the process of designing the new processing system 200n very soon after the functionality of the new processors C1n-C4n has become known.

The solution described above also makes it possible to use the preceding test plan (with slight modifications if necessary), and also any file of signals awaited for automatically controlling the outcome of the simulation process.

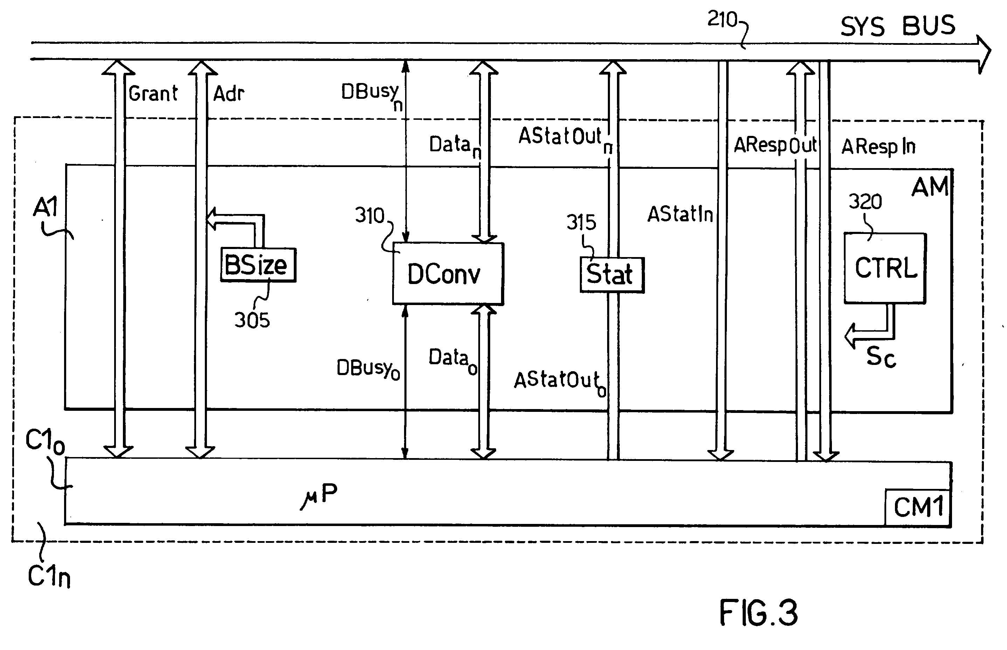

The functionality of the adapting modules A1-A4 (and consequently their functional model) will be described by considering the structure of a generic adapting module, for example the adapting module A1, as shown in Fig. 3 (the elements previously represented in Fig. 2b are identified by the same reference numbers or symbols).

The old processor C1o is connected directly to the system bus 210 (control bus) to send and receive signals (some of them along dedicated point-to-point lines), indicated as a whole by Grant, which can be used for controlling a request for access and a granting of access to the system bus 210 (address bus and data bus).

A value (Adr) containing an address of a data element, a type of operation requested (for example reading, reading with the intention of modifying the data, or writing), a label identifying a requesting processor and a transaction relating to it (the data elements not being controlled in an ordered flow, and therefore being supplied to the requesting processor in any sequence, or "out of order"), the number of blocks constituting the data element (burst size), and similar, is transmitted along the bus 210 (address bus). Assuming that the data element used by the old processor C1o and that used by the new processor C1n consist of different numbers of blocks, the old processor C1o is connected directly to the system bus 210 to receive the value Adr, and is connected directly to the system bus 210 to send the value Adr, with the exception of a portion of the value which identifies the number of blocks, this being supplied by a unit (Bsize) 305 of the adapting module A1.

The various blocks of each data element (with which a corresponding identifying label is associated) are transmitted in sequence along the bus 210 (data bus). The adapting module A1 includes a data conversion unit (DConv) 310, consisting essentially of one or more shift registers, which is connected directly to the data bus to send and receive a data element Datan. The conversion unit 310 is also connected to a line of the system bus 210 (control bus) used to transmit a signal DBusyn indicating that the data bus is busy (with a duration variable as a function of the length of the data element transmitted). The conversion unit 310 is connected to the old processor C1o to transmit a data element Datao and a signal DBusyo, corresponding to the data element Datan and to the signal DBusyn respectively. Preferably, the conversion unit 310 is made with separate input and output registers, in such a way that the reception of data from the system bus 210 and the sending of data to the system bus 210 can be overlapped in time (at least partially).

The old processor C1o is connected to a status unit (Stat) 315 of the adapting module A1 to send a signal AStatOuto indicating a status of a transaction carried out on the system bus 210; the status unit 315 is connected to dedicated lines of the system bus 210 (control bus) to send a corresponding status signal AStatOutn to the arbitration unit. The old processor C1o is also connected to multi-point lines of the system bus 210 (control bus) to receive a collective status signal of the transaction AStatIn, sent by the arbitration unit.

The old processor C1o is connected directly to dedicated lines of the system bus 210 (control bus) to send (to the arbitration unit) a signal ARespOut indicating a result of a snooping process. The snooping process is used to check a coherence of the data of the shared memory replicated in the various cache memories; in particular, the agents of the processing system continuously monitor the data read/write requests sent along the system bus 210, to check whether these data are present in their cache memories. The old processor C1o is also connected to multi-point lines of the system bus 210 (control bus) to receive a signal of the collective result of the snooping process ARespIn, sent by the arbitration unit.

A control unit (CTRL) 30 controls the operation of the adapting module A1 by means of suitable control signals (indicated as a whole by Sc).

Similar considerations are applicable in cases in which the old processor C1o is connected directly to the lines of the system bus 210 to which the signals Gant, AStatIn, ARespOut, ARespIn are transmitted (without passing through the adapting module A1), the adapting module has a different structure, other types of signal are used to control the protocol for communication with the system bus, or similar.

Typically, the information received in the new processor C1n from the system bus 210 and sent by the new processor C1n along the system bus 210 have a new format, differing at least partially from an old format of the corresponding information received and sent by the old processor C1o. The adapting module A1 operates as a physical interface between the old processor C1o and the system bus 210. The information in the new format are received in the adapting module A1 from the system bus 210, are converted into the old format and are sent to the old processor C1o; conversely, the information in the old format are received in the adapting module A1 from the old processor C1o, are converted into the new format and are sent along the system bus 210.

In particular, the length of a data element in the new format is very frequently greater than that of a data element in the old format; commonly, the length of a data element in the new format is two, three, or four times greater than, or more generally a multiple by an integer N of, the length of the data in the old format, and therefore each data element in the new format consists of N portions (for example, two), each having a length equal to that of the data element in the old format.

In a preferred embodiment of the present invention, during a phase of initialization of the simulation program, a corresponding data element in the old format is replicated in each portion of each data element (in the new format) stored in the shared memory. For example, assuming that a data element in the old format consists of 4 blocks of 16 bytes (64 bytes), while the data element in the new format consists of 8 blocks of 16 bytes (128 bytes). In this case, a first half of each data element in the shared memory will be identical to a second half of the element. Given a generic data element stored at 8 consecutive locations of the shared memory, if the blocks B0, B1, B2 and B3 are stored in the first 4 locations, the same blocks B0, B1, B2 and B3 are stored in the 4 locations immediately following, and therefore the data element is equal to B0, B1, B2, B3, B0, B1, B2 and B3.

The solution described above is exclusively applicable to processing data, in other words those containing values to be processed, intermediate results and final results of the processing. The data containing instructions, on the other hand, are normally stored in the shared memory. At each request to read an instruction (assuming that the instructions are never modified), the adapting module A1 receives a data element containing two consecutive instructions and supplies the requested instruction to the old processor C1o. This makes it possible to use the programs of the old processing system directly, without any modification.

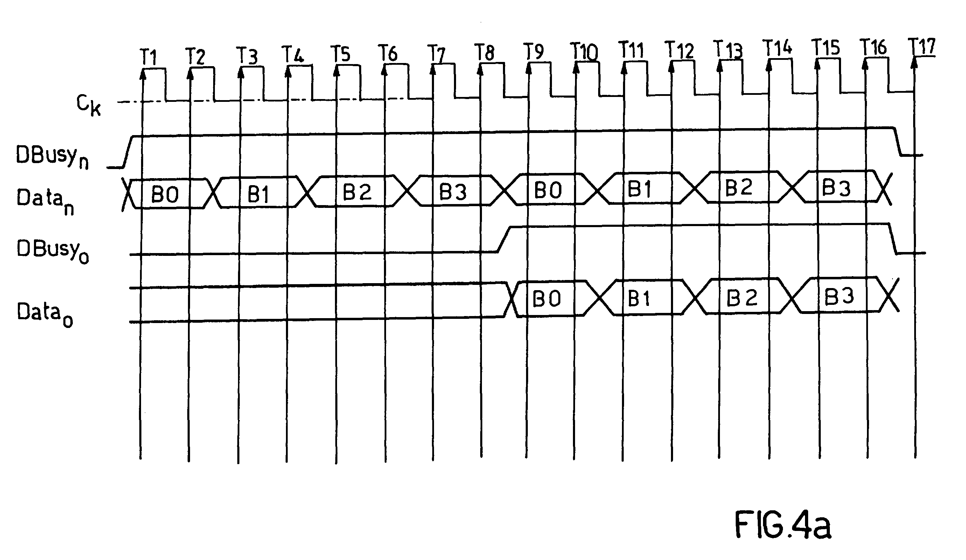

For the purpose of describing an example of a transaction of reading a processing data element carried out by the new processor C1n, reference should be made jointly to Fig. 3 and to the timing diagram in Fig. 4a. As usual, the various signals are set or reset, in other words they are switched to a high or low value (or vice versa), at the rising front of the clock signal Ck; at a subsequent rising front (after one or more periods of the clock signal Ck) the status of the signals is stable and can be recognized (strobed); a signal consisting of a single bit is represented by a single line, while signals comprising more than one bit are represented by a strip (the crossover points are the instants of switching).

It is assumed that a data element in the new format Datan, consisting of the blocks B0, B1, B2, B3, B0, B1, B2 and B3, is sent along the system bus 210 by a module of the new processing system, for example the memory control unit, in order to be received by the new processor C1n. The memory control unit sets the signal DBusyn at an initial instant T1, and then sends the blocks B0, B1, B2, B3, B0, B1, B2 and B3 in sequence along the data bus; the transfer of each block requires, for example, 2 periods of the clock signal Ck, and therefore the operation terminates at the instant T16, with the DBusyn signal which is reset at the same time. This data element is thus received by the conversion unit 310 of the adapting module A1.

The conversion unit 310 uses the blocks of the first half of the received data element (B0, B1, B2 and B3) to form a corresponding data element Datao in the old format. In particular, as soon as the adapting module A1 has received the first half of the data element in the new format (and more generally a penultimate portion of the data element), at the instant T9, the DBusyo signal is set and the blocks B0, B1, B2, B3 are sent in sequence to the old processor C1o. The operation terminates at the instant T16, with the DBusyo signal which is reset at the same time.

It should be noted that the old processor C1o thus completes the reception of the data element in the old format Datao at the same instant (T16) at which the transmission of the data element in the new format Datan along the system bus 210 terminates; this prevents the old processor C1o from being able to carry out operations on the system bus 210 while the bus is still busy with the transmission of the data element in the new format Datan.

This solution also makes it possible to automatically supply the data element Datao to the old processor C1o with the required alignment. This is because the new processor C1n may require the data element Datan to start from any chosen block in the range from the block in position 0 to the block in position 7, while the old processor C1o may require the data element Datao to start from any chosen block in the range from the block in position 0 to the block in position 3. First of all, the unit 310 converts the required alignment to a value acceptable to the old processor C1o; for this purpose, it is sufficient to divide the alignment required by the new processor C1n by the number of blocks of the data element in the old format (4 in the example in question) and to consider the remainder of this division. The received blocks are then supplied to the old processor C1o in sequence, starting from this block. Assuming, for example, that the new processor C1n requires the data element Datan, aligned so that it starts from the block in position 5 (block B1), corresponding to the block in position 1 (5 - INT [5/4]•4) of the data element Datao; in this case, the conversion unit 310 supplies the old processor C1o with the data element starting from the block in position 1 (block B1) and continuing in sequence with the blocks in positions 2, 3 and 4 (blocks B2, B3 and B4) as received from the system bus 210, without any need to return to the start of the data element (wrap).

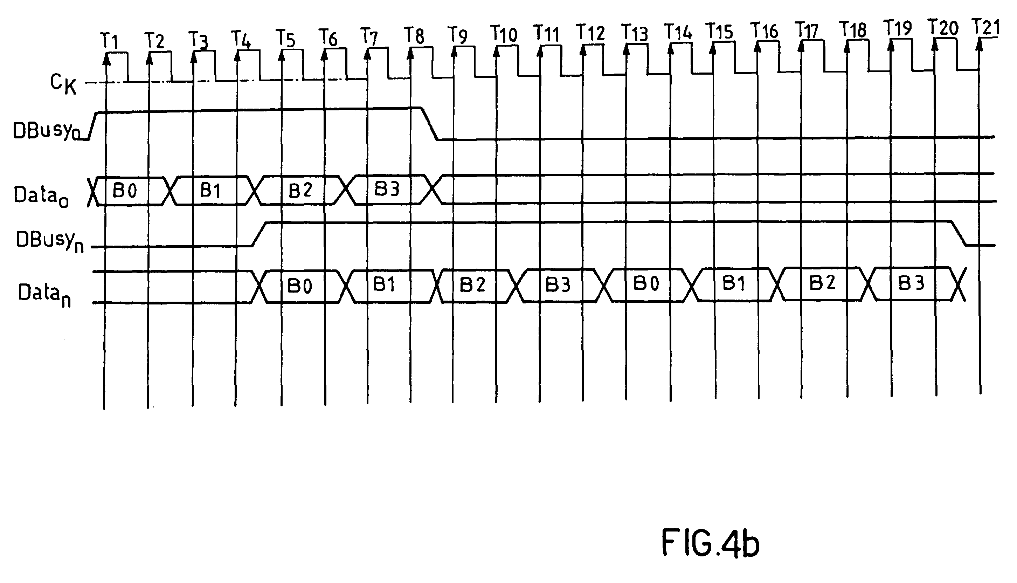

Reference will now be made jointly to Fig. 3 and the timing diagram in Fig. 4b to describe an example of a transaction of writing a data element (for processing), required for a writing or intervention cycle, and carried out by the new processor C1n.

It is assumed that the old processor C1o sets the DBusyo signal at an initial instant T1 and sends the blocks B0, B1, B2, B3 of a data element in the old format Datao in sequence to the conversion unit 310 of the adapting module A1; the operation terminates at the instant T8, with the DBusyo signal which is reset at the same time.

The conversion unit 310 then sends the blocks of the received data element B0, B1, B2 and B3 in succession on two consecutive occasions (or, more generally, N times) along the system bus 210. In particular, as soon as the block B1 (or any other block) has been received, the DBusyn signal is set and the blocks B0, B1, B2, B3, B0, B1, B2 and B3 are sent in sequence along the system bus 210, in such a way as to simulate the sending of a corresponding data element in the new format Datan, which is received, for example, by the memory control unit. The operation terminates at the instant T20, with the DBusyn signal which is reset at the same time.

It should be noted that the old processor C1o terminates the sending (to the adapting module A1) of the data element in the old format Datao before the corresponding data element in the new format Datan has actually been sent along the system bus 210; the old processor C1o could therefore become free for new operations while the new processor C1n is busy sending the data element in the new format Datan along the system bus 210. In the illustrated structure, when the adapting module A1 receives an address Adr for checking an associated transaction, this address is transmitted directly to the old processor C1o; the old processor C1o generates the corresponding status signal AStatOuto which is supplied to the status unit 315 of the adapting module A1. Normally, this signal is transmitted directly (signal AStatOutn) along the system bus 210 so that it can be received by the arbitration unit. However, if the adapting module A1 is busy sending a data element in the new format Datan along the system bus 210, the status unit 315 automatically modifies the AStatOutn signal, replacing it with a value (Retry) indicating that the new processor C1n is busy, and therefore further transactions will be cancelled and repeated successively (retried).

In the embodiment of the present invention described above, the snooping process is controlled directly by the old processor C1o. When the adapting module A1 receives an address Adr to check the coherence of an associated data element in the new format, this address is transmitted directly to the old processor C1o. The old processor C1o checks the coherence of the corresponding data element in the old format and generates the signal of the result of the snooping process ARespOut, which is transmitted directly along the system bus 210 so that it can be received by the arbitration unit; this result is also applied automatically to the corresponding data element in the new format, with the sole difference that the address of the snooping process is aligned with a density of the data in the new format (128 bytes instead of 64 bytes in the example in question).

Similar considerations are applicable if there are other differences between the data in the old and new formats, for example if the blocks have different lengths, the data elements use different parity bits, or similar.

Preferably, the adapting module A1 does not completely simulate the functionality of the new processor C1n (except at its physical interface with the system bus 210), although the opposite case is not excluded; for example, the adapting module A1 does not simulate any additional instructions of the new processor C1n, or the different internal queues of the new processor C1n (and therefore it is not possible to check the behaviour of the new processing system in the case of beat phenomena, in which a plurality of agents need to block the same sector of the shared memory in an exclusive way for a subsequent modification of a data element contained in the memory). This choice, however, does not adversely affect the ability to check the interaction of the new processors with the other modules of the new processing system, and at the same time it enables the construction of the functional model of the adapting modules to be kept relatively simple.

Clearly, a person skilled in the art may, in order to meet contingent and specific requirements, make numerous modifications to, and variations of, the method for simulating a data processing system described above, all these modifications and variations being contained within the scope of protection of the invention, as defined by the following claims.

## Claims

1. Method for simulating a new data processing system (200n), formed from a corresponding old processing system (200o), comprising a plurality of interconnected modules (C1o-C4o, 215, 220, 225, 230) and in which at least one new of the modules (C1n-C4n) replaces at least one corresponding old module (C1o-C4o) of the old processing system (200o), the method comprising the step of supplying a functional model of the at least one old module (C1o-C4o) for simulating its functionality,
characterized by the steps of :
supplying the functional model of at least one adapting module (A1-A2) associated with the at least one old module (C1o-C4o) and connecting logically the at least one adapting module (A1-A4) between the at least one old module (C1o-C4o) and the other modules (215, 220, 225, 230) of the new processing system (200n), the functional model of the at least one old module (C1o-C4o) and of the at least one adapting module (A1-A4) being capable of simulating, at least partially, the functionality of the corresponding at least one new module (C1n-C4n).

2. Method according to Claim 1, additionally comprising the simulation steps of:
receiving in the at least one adapting module (A1) information (Datan) in a new format for the at least one new module (C1n) sent by the other modules (215, 220, 225, 230) of the new processing system (200n),
converting the information received in the new format (Datan) into corresponding information (Datao) in an old format for the at least one old module (C1o),
sending the data converted into the old format (Datao) to the at least one old module (C1o).

3. Method according to Claim 2, additionally comprising the simulation steps of:
receiving in the at least one adapting module (A1) information in the old format (Datao) sent by the at least one old module (C1o),
converting the information received in the old format (Datao) into corresponding information (Datan) in the new format,
sending the information converted into the new format (Datan) to the other modules (215, 220, 225, 230) of the new processing system (200n).

4. Method according to Claim 2 or 3, in which the information include processing data elements, each data element in the new format (Datan) comprising N portions, each having a length equal to a length of the data element in the old format (Datao), and in which the new processing system (200n) includes at least one memory (220) for storing the data elements in the new format (Datan), the method additionally comprising the simulation step of initializing the memory (220) by replicating, in the portions of each data element in the new format (Datan), the corresponding data element in the old format (Datao).

5. Method according to Claim 4, in which each data element in the old and new formats comprises a plurality of blocks transmitted in sequence along a bus (210), each portion of the data element in the new format (Datan) comprising a number of blocks equal to a number of blocks of the data element in the old format (Datao), the method additionally comprising the simulation steps of:
receiving in sequence in the at least one adapting module (A1) the blocks (B0, B1, B2, B3, B0, B1, B2, B3) of a data element in the new format (Datan) transmitted along the bus (210),
sending in sequence the blocks (B0, B1, B2, B3) of a portion of the data element received in the new format (Datan) to the at least one old module (C1o).

6. Method according to Claim 5, in which the step of sending in sequence the blocks (B0, B1, B2, B3) of a portion of the data element received in the new format (Datan) to the at least one old module (C1o) is carried out as soon as a penultimate portion of the data element in the new format (Datan) is received in the at least one adapting module (A1).

7. Method according to Claim 5 or 6, additionally comprising the simulation steps of:
receiving in sequence in the at least one adapting module (A1) the blocks (B0, B1, B2, B3) of a data element in the old format (Datao) sent by the old module (200o),
repeating N times the step of sending in sequence the blocks (B0, B1, B2, B3) of a data element received in the old format (Datao) along the bus (210).

8. Method according to Claim 7, additionally comprising the simulation steps of:
receiving in the at least one old module (C1o) a request for checking a transaction (Adr) transmitted along the bus (210),
receiving in the at least one adapting module (A1) a signal (AStatOuto) indicating a status of the transaction sent by the at least one old module (C1o),
modifying the received status signal (AStatOuto) by replacing it with a value indicating a busy status (Retry) of the at least one new module (C1n) if the at least one adapting module (A1) is carrying out the step of sending in sequence the blocks (B0, B1, B2, B3) of the data element received in the old format (Datao) along the bus (210),
sending the modified status signal (AStatOutn) along the bus (210).

9. Method according to Claim 8, additionally comprising the simulation steps of:
receiving in the at least one old module (C1o) a request for checking the coherence of a data element in the new format (Datan) transmitted along the bus (210),
checking the coherence of the corresponding data element in the old format (Datao),
sending a signal (ARespOut), indicating a result of the check, along the bus (210).

10. Simulator (100) for a new data processing system (200n), formed from a corresponding old processing system (200o), comprising a plurality of interconnected modules (C1o-C4o, 215, 220, 225, 230) and in which at least one new of modules (C1n-C4n) replaces at least one corresponding old module (C1o-C4o) of the old processing system (200o), the simulator comprising means (140) for supplying a functional model of the at least one old module (C1o-C4o) for simulating its functionality,
characterized in that
it includes means (140) for supplying the functional model of at least one adapting module (A1-A2) associated with the at least one old module (C1o-C4o) and means (145) for connecting logically the at least one adapting module (A1-A4) between the at least one old module (C1o-C4o) and the other modules (215, 220, 225, 230) of the new processing system (200n), the functional model of the at least one old module (C1o-C4o) and of the at least one adapting module (A1-A4) being capable of simulating, at least partially, the functionality of the corresponding at least one new module (C1n-C4n).
